# EUROPEAN PATENT APPLICATION

(11) **EP 1 950 859 A2**
(43) Date of publication of application: **30.07.2008**
(21) Application number: 08250172.7
(22) Date of filing: 14.01.2008
(51) Int. Cl.: H02H 3/12

(54) **Electrical safety device**

(30) Priority: 25.01.2007 GB 0701410
(71) Applicant: Technetix Group Limited, Burgess Hill West Sussex RH15 9TZ (GB)
(72) Inventor: Chapman, Paul Technetix Group Lim. of Communications House, West Sussex, RH15 9TZ (GB); Rijssemus, Martien Tratec Telecom B.V., 3903 LP Veenendaal (NL)
(74) Representative: Willett, Christopher David

(57) **Abstract**

There is provided an electrical safety device (30) comprising electrical connection means insertable into a mains electricity power socket and a switch (36) connected to at least one element of an in-home network such as that associated with a cable TV and/or broadband. The switch (36) is responsive to the electrical connection means (32 : 34) to complete an electrical path when the electrical connection means is inserted into a mains power socket. By routing the electrical circuit of the in-home network through the switch (36), electricity flow through the in-home network will only be enabled when the electrical connection means is inserted into a mains power socket, and the switch (36) completes the electrical path. There is also provided an in-home network comprising an electrical safety device (30) connected to one of a plurality of electrical elements in the network. The electrical connection means is a plug 32 or a plug incorporating a transformer 34.

## Description

### Field of the Invention

This invention relates to an electrical safety device for use in in-home networks such as those associated with cable TV and broadband installations. The invention also relates to an in-home network incorporating such an electrical safety device.

### Background of the Invention

Users of cable TV and broadband networks generally receive a cable feed from the network provider along a coaxial cable. Where the cable enters the home, it is connected to a galvanic isolator which is a safety device to isolate the user's in-home electrical apparatus, such as a television set, computer, from the cable feed so that no dangerous voltages can travel from the in-home network to the cable feed, or alternatively, from the cable feed to the in-home network. The in-home network should also be connected to a safety ground to further enhance safety. If there is a malfunction somewhere in the system, for example at the terminal set of a computer, that permits the outer conductor or shielding of coaxial cables associated with the in-home network to carry a dangerous voltage, for example the mains voltage, the safety grounding will ensure that this voltage is short-circuited to ground. In this way no dangerous voltage occurs on the shielding of any in-home coaxial cables, which could be touched by the user.

If the in-home network is self-installed, then there is no guarantee that a non-professional installer will connect the in-home network to a proper safety ground. To address this problem, it has previously been proposed to mount isolators in every lead of the in-home network to limit the migration of a dangerous voltage in the in-home network. This is, however, an expensive and only partial solution since if there is a malfunction, there is still one coaxial lead left that does carry a dangerous voltage.

The present invention aims to provide an electrical safety device which addresses this problem.

### Summary of the Invention

In accordance with a first aspect of the invention, there is provided an electrical safety device comprising electrical connection means insertable into a mains electricity power socket and a switch element connected to at least one element of an in-home network, wherein the switch element is responsive to the electrical connection means to complete an electrical path when the electrical connection means is inserted into a mains power socket. By routing the electrical circuit of the in-home network through the switch element, electricity flow through the in-home network will only be enabled when the electrical connection means is inserted into a mains power socket, and the switch element completes the electrical path. If the electrical connection means is not inserted into the mains power socket, then the switch element does not complete the electrical path and electricity cannot flow through the in-home network. The electrical wiring, and thus power sockets, of a user's dwelling are conventionally connected to a safety ground for electrical safety. As the in-home network will only operate when the electrical connection means is placed in a mains electricity power socket, this ensures a connection to ground is made by way of the user's main housing electrical wiring, ensuring that any dangerous voltages are short-circuited to ground.

In accordance with another aspect of the invention, there is provided an in-home network, such as that associated with cable TV and/or broadband, comprising a plurality of electrical elements such as, by way of example, a set-top box, monitor, splitter, and/or amplifier, wherein the network also comprises an electrical safety device as aforesaid connected to one of the electrical elements.

In accordance with either aspect of the present invention, the electrical connection means may be a plug. Alternatively, the electrical connection means may be a plug incorporating a transformer which powers the safety device by a lower voltage than when the plug alone is used.

The switch element may comprise a switch and a relay or a switch and solid state device, the relay or solid state device operable in response to the electrical connection means to alter the switch position to complete or break the electrical path.

The switch element may further comprise electrical elements, such as capacitors and inductors, to protect from dangerous voltages on an inner conductor of a coaxial lead and also power surges. Typically inductors are connected in parallel to short circuit dangerous voltages on the inner conductor to associated shielding.

Alternatively, protection against power surges may be achieved by the switch element further comprising surge arrestors.

The invention will now be described, by way of example, with reference to the accompanying drawings in which:
Figure 1 is a schematic representation of an in-home network with an external cable feed;
Figure 2 is a diagram of a first embodiment of an electrical safety device in accordance with the present invention;
Figure 3 is a diagram of a second embodiment;
Figure 4 is a diagram of a third embodiment; and
Figure 5 is a diagram of a fourth embodiment.

### Description

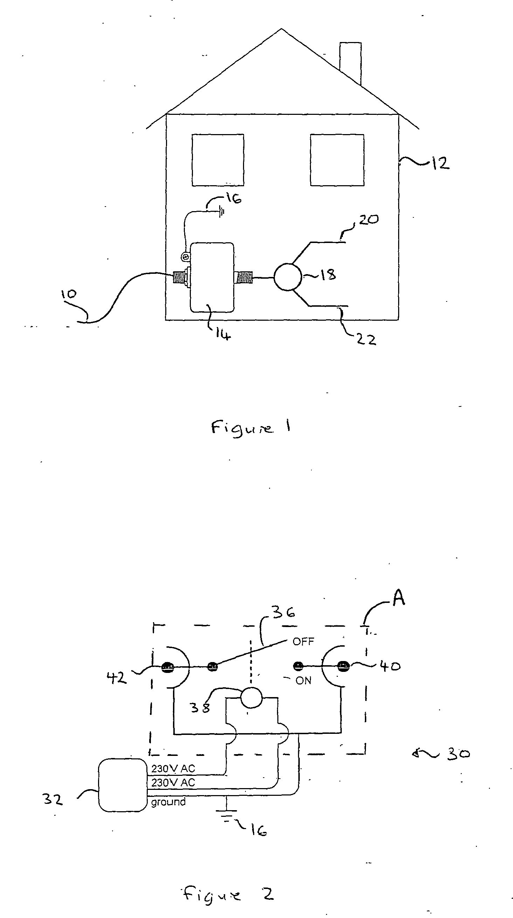

Figure 1 depicts a simplified representation of a coaxial cable 10 carrying a cable feed from a network provider as it enters a house 12. The cable 10 is routed through a galvanic isolator 14 which can withstand DC voltages up to 2120 V and AC leakage current is limited to 8mA max. The isolator 14 is connected to a safety ground 16 before reaching a splitter 18 which splits the signal along two paths 20 and 22 to electrical equipment within the home, for example a computer connected to path 20 and a television connected to path 22. The in-home network is the various electrical elements within the user's home that are connected to the external cable TV/broadband provider via the external cable feed. In this prior art arrangement, the galvanic isolator 14 isolates the in-home installation from the external cable feed so no dangerous voltages can travel from the in-home installation of the cable feed, or alternatively, from the cable feed to the in-home installation. If the in-home network is installed by a non-professional, for example a do-it-yourself installer, then the galvanic isolator may not be connected to a proper safety ground as most in-home installations are situated in the living room where proper safety ground points tend not to be readily accessible.

Various embodiments of an electrical safety device 30 in accordance with the present invention will now be described with reference to Figures 2 to 5. The electrical device in its various embodiments is typically part of a self-installation kit as supplied by a network operator.

Figure 2 illustrates a first embodiment in which the safety device 30 consists of a plug 32 connected to a switch 36 by way of a 280V AC relay 38. When the plug 32 is inserted into a mains electricity socket, the relay 38 is activated to move the switch 36 from an off position to an on position and so establish an electrical path through the electrical safety device. Connector points 40 and 42 are connected within the electrical path of the in-home network, such that if the plug 32 is not connected into the mains electricity power supply, the relay 38 will not be operated, the switch 36 will not be closed and the electrical path will remain broken and the in-home network inoperable. Generally the electrical safety device is incorporated into one of the in-home network elements, for example by placing the components within box A within splitter 18, or an amplifier.

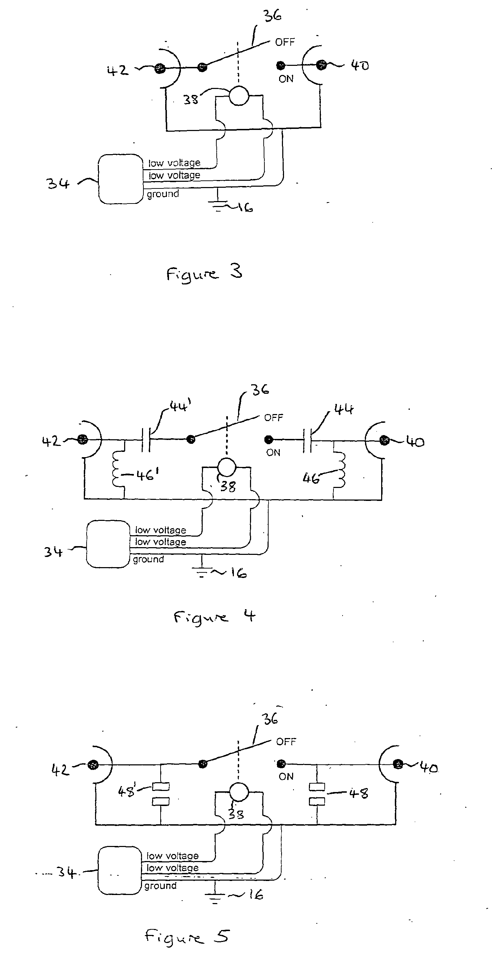

Figure 3 illustrates a second embodiment of device 30 where a plug incorporating a power adapter 34 or transformer is used instead of a normal plug 32, so that the device 30 is powered by a lower voltage than for the first embodiment. The relay 38 is a low voltage relay.

A third embodiment shown in Figure 4 is similar to the second embodiment but incorporates capacitors 44, 44' and inductors 46, 46'. The inductors 46, 46' short-circuit dangerous voltage from an inner conductor of a coaxial lead via shielding to ground 16. Capacitors 44, 44' protect the relay 38 from potential damage should this occur. By selecting appropriate capacitors and inductors, protection can be provided against surge pulses such as those induced by lightening.

The fourth embodiment shown in Figure 5 uses surge arrestors 48, 48', instead of capacitors and inductors, to protect against surge pulses.

Whilst the embodiments use a relay 38 to activate the switch 36, as will be understood by a person skilled in the art, solid state devices can be used instead of a relay to complete the electrical path between connectors 40 and 42.

Using the electrical safety device 30, the in-home network is only fully functional if the self-installer inserts the power plug 32 or adapter 34 into a mains electricity source and the relay in consequence becomes switched to the on position. With the power plug 32 or adapter 34 connected into the mains electricity supply by way of a normal electricity socket, the in-home network is automatically connected to a proper safety ground. This ensures that a do-it-yourself installer has no other option than to connect the network to a safety ground for operation of the in-home network to occur.

## Claims

1. An electrical safety device (30) comprising electrical connection means including a plug (32) insertable into a mains electricity power socket and a switch element (36) connected to at least one element of an in-home network, wherein the switch element is responsive to the electrical connection means to complete an electrical path through the safety device when the plug is inserted into a mains power socket and to ensure a connection to ground for the in-home network by way of the user's mains electricity supply.

2. An electrical safety device according to claim 1, wherein the electrical connection means is a plug incorporating a transformer.

3. An electrical safety device according to either of the preceding claims, wherein the switch element comprises a switch (36) and a relay (38), the relay operable in response to electrical connection means to alter the switch position to complete or break the electrical path.

4. An electrical safety device according to claim 1 or 2, wherein the switch element comprises a switch and solid state device, the solid state device operable in response to electrical connection means to alter the switch position to complete or break the electrical path.

5. An electrical safety device according to any of the preceding claims, wherein the switch element further comprises electrical components (44, 44', 46, 46') to protect against power surges.

6. An electrical safety device according to any of the preceding claims, wherein the switch element further comprises surge arresters.

7. An in-home network comprising a plurality of electrical elements, wherein the network also comprises an electrical safety device connected to one of the electrical elements, wherein the electrical safety device is in accordance with any of the preceding claims.
